(19) **Europäisches Patentamt**
**European Patent Office**
**Office européen des brevets**

(11) **EP 1 380 077 B1**

(12) **EUROPEAN PATENT SPECIFICATION**

(45) Date of publication and mention
of the grant of the patent:
**14.02.2007 Bulletin 2007/07**

(21) Application number: **01930425.2**

(22) Date of filing: **19.03.2001**

(51) Int Cl.:
***H01S 5/20*** (2006.01)

(86) International application number:
**PCT/US2001/008941**

(87) International publication number:
**WO 2002/075878 (26.09.2002 Gazette 2002/39)**

(54) **A METHOD AND APPARATUS FOR IMPROVING EFFICIENCY IN OPTO-ELECTRONIC RADIATION SOURCE DEVICES**

VERFAHREN UND VORRICHTUNG ZUR VERBESSERUNG DES WIRKUNGSGRADS IN OPTOELEKTRONISCHEN STRAHLUNGSQUELLENEINRICHTUNGEN

PROCEDES ET APPAREILS AMELIORANT L'EFFICACITE DE DISPOSITIFS SOURCES DE RAYONNEMENT OPTOELECTRONIQUE

(84) Designated Contracting States:
**CH DE FR GB IT LI NL**

(43) Date of publication of application:
**14.01.2004 Bulletin 2004/03**

(73) Proprietors:
- **Trumpf Photonics, Inc.**
**Cranbury, NJ 08512 (US)**
- **Garbuzov, Dmitri Zalmanovitch**
**Princeton, NJ 08540 (US)**
- **Menna, Raymond J.**
**Newtown, PA 18940 (US)**

(72) Inventors:
- **GARBUZOV, Dmitri, Zalmanovitch**
**Princeton, NJ 08540 (US)**
- **MENNA, Raymond, J.**
**Newtown, PA 18940 (US)**

(74) Representative: **Müller-Boré & Partner**
**Patentanwälte**
**Grafinger Strasse 2**
**81671 München (DE)**

(56) References cited:
| | |
|---|---|
| EP-A- 0 540 799 | EP-A- 0 575 684 |
| EP-A- 0 690 536 | EP-A- 0 851 547 |
| EP-A- 0 959 540 | US-A- 4 323 859 |
| US-A- 4 366 569 | US-A- 5 987 047 |

- GARBUZOV D ET AL: "Broadened waveguide, low loss 1.5 /spl mu/m InGaAsP/InP and 2 /spl mu/m InGaAsSb/AlGaAsSb laser diodes" 1997 INT. CONFERENCE ON INDIUM PHOSPHIDE AND RELATED MATERIALS. HYANNIS, CAPE COD, MAY 11 - 15, 1997, INDIUM PHOSPHIDE AND RELATED MATERIALS, NEW YORK, NY : IEEE, US, 11 May 1997 (1997-05-11), pages 551-554, XP010232042 ISBN: 0-7803-3898-7
- PATENT ABSTRACTS OF JAPAN vol. 1997, no. 06, 30 June 1997 (1997-06-30) & JP 09 045989 A (MITSUI PETROCHEM IND LTD), 14 February 1997 (1997-02-14)

## Description

<u>FIELD OF THE INVENTION</u>

This invention relates to semiconductor opto-electronic technology, and more particularly, high power opto-electronic devices, such as high power semiconductor lasers, amplifiers, gain chips and superluminescence Light Emitting Diodes (SLEDs) having improved efficiency and low beam divergence for telecom applications.

<u>BACKGROUND OF THE INVENTION</u>

Document EP 0 575 684 A1 discloses a semiconductor opto-electronic device, comprising an active region, a single quantum well layer or a multi-quantum well layer, embedded in a carrier confinement structure providing for an energy barrier at least on one side of the active region. This energy barrier reduces carrier leakage out of the active region. The carrier confinement structure is embedded in an optical confinement structure which guides the optical light wave.

Document EP 0 540 799 A1 discloses a semiconductor opto-electronic device having an active region between very thin p- and n-doped barrier layers and thick p- and n-doped cladding layers. The barrier layers are employed to avoid tunneling and spill over of carriers from the active region into the cladding.

Document Garbuzov D. et. al: 'Broadband waveguide, low loss 1.5/spl mu/m InGaAsP/InP and 2/spl mu/m InGaAsSb/AlGaAsSb laser diodes', 1997 Int. Conference on Indium Phosphide and Related Materials, Hyannis, Cape Cod, May 11-15, 1997, Indium Phosphide and Related Materials, New York, NY: IEEE, US, 11 May 1997 (19997-05-11), pages 551-554, XP010232042, ISBN: 0-7803-3898-7 discusses free carrier absorption in cladding layers of long wavelength, separate confinement quantum well laser diodes, and shows that such absorption limits the differential efficiency and output power for such lasers if their waveguide thickness is designed from the considerations of the maximum optical confinement factor for quantum wells.

Opto-electronic devices, such as semiconductor lasers and SLEDs provide the light source for different aspects of fiber-optic telecommunication systems. Opto-electronic radiation source devices, such as lasers, having wavelength outputs ranging from 1.31 to 1.55 microns ($\mu$m) are the most commonly used lasers for telecommunication operation. Radiation source devices with wavelengths of 1.31 $\mu$m are typically used for short distance transmission and cable TV signals, while wavelengths of 1.42-1.6 $\mu$m are typically used for fiber optic communications. Lasers having wavelengths in the range of 1.42 to 1.48 $\mu$m are typically used as pump lasers for Raman and Erbium Doped Fiber Amplifiers (EDFA). In long distance transmission one desires to use, for example, lasers having wavelengths between 1.54 to 1.56 $\mu$m. For all telecom applications and especially for EDFA pump sources, operating currents for semiconductor sources exceed by more than an order of magnitude the threshold current.

Essentially, as one can ascertain from the prior art, a weak temperature dependence of the main laser characteristics is extremely important for telecom lasers. As one knows in the prior art, it is not easy to keep high performance at elevated temperatures for lasers operating in the wavelength range of 1.3-1.5 $\mu$m. A widely used material for telecom lasers is InGaAsP compounds grown on InP substrates. Numerous investigations of InGaAsP/InP lasers have demonstrated that the strong temperature degradation of their parameters is partially associated with insufficient high energy level barriers for confinement of the electrons in the laser active region. As a result of the low barrier in the conduction band, some of the electrons injected from n-doped cladding layer passes through the active region and are lost in the p-doped cladding layer. There are many investigators that have looked at this problem, and people have provided various solutions to decrease electron leakage at elevated temperatures. For example, see an article entitled, "Lasing Characteristics Under High Temperature Operation of 1.55 $\mu$m Strained InGaAsP/InGaAlAs MQW Laser With InAlAs Electron Stopper Layer" by H. Murai et al., published in Electronics Letters on November 23, 1995, Volume 31, Number 24. In that paper there is shown a 1.55 $\mu$m strained InGaAsP/InGaAlAs MQW laser in which InGaAlAs cladding layers and InAlAs electron stopper layer have been incorporated to reduce electron leakage current. The device showed low threshold current with high maximum temperature of CW operation. As indicated in the paper, superior lasing characteristics were demonstrated through comparison with conventional strained MQW lasers without electron stop layer. A similar design was used for the fabrication of 1.3 $\mu$m lasers that could operate without thermoelectric coolers. Such lasers are required for subscriber networks and optical interconnection systems. See, for example, an article entitled, "High Temperature Operation of AlGaInAs Ridge Waveguide Lasers With a p-AlInAs Electron Stopper Layer" published in Japanese Journal of Applied Physics on pages 1230 through 1233 by Takemasa et al.

As can be seen in these papers, there are band diagrams that show the active region of the laser including Quantum Wells (QW) sandwiched between layers of materials with a band gap larger than that of the active region. Thus energy barriers confining the injected electrons and holes in the active region are created. The prior art utilized InGaAsP and InP to create an active region and barriers for lasers operating in the 1.2 to 2.0 $\mu$m range. The disadvantage of these material is that the energy barriers for electrons is lower than that for holes and when one wants to inject electrons to generate photons in the QWs, there is a leakage of electron current from active region to the p-doped InP cladding layer that limits laser performance. This leakage current component is superlinearly related to total current and temperature sensitive, in that as the leakage current increases at a rate greater than an increase in the total current. The problem is more severe for lasers operating at 1.3 $\mu$m than for lasers that operate at 1.55 $\mu$m. In fact, the problem is so severe that one employs AlInGaAs as a cladding layer material or AlInAs as a stop-electron (blocking) layers.

However, aluminum compounds are not desirable for telecommunication devices because aluminum easily oxidizes and thus creates problems for laser fabrication as well as for long term reliability. The prior art has attempted to solve this problem by using a InGaP large band gap material as a blocking layer. The additional problem for InGaAsP/InP telecom lasers arises at operation at high current densities. Measurements of output power versus current (P-I characteristics) at both short pulsed regime and continuous wave (CW) regime demonstrate the transition from a linear performance to a sublinear performance at high current density. This phenomenon is called the P-I characteristic rollover or saturation effect. In the short pulse regime, where device heating is negligible, the saturation effect is purely current induced and is associated with an increase of the electron concentration and electrical field at the active region/p-doped cladding layer interface. The result is that the electron current component that is directed from the active region to the p-doped clad layer increases. In the CW regime this current component increases additionally due to heating of the active region caused by the high current. Several publications (See, for example, an article entitled, "Effect of Heterobarrier Leakage on the Performance of High-Power 1.5 $\mu$m InGaAsP Multiple-Quantum Well Lasers" published in Journal of Applied Physics on pages 2211-2215 by Shterengas et al.) indicated that the increase of p-doping of the active region/p-doped clad interface allows the decreasing of the electron leakage due to the reduction of the interface electrical field. However, the increase of the hole concentration can lead to the decrease of laser efficiency caused by the additional optical losses associated with the strong photon absorption by free holes. In order to solve this problem, a broad waveguide (BW) design was suggested in U.S. Patent 5,818,860, entitled "High Power Semiconductor Laser Diode," issued October 6, 1998, to Garbuzov, the inventor herein. In the case of BW lasers, 99% of the optical mode is confined in the broadened waveguide with total thickness of about 1 $\mu$m. The waveguide material is undoped thus providing minimum optical losses for lasing mode. The broad waveguide design was very useful for the fabrication of high power, high efficient diode lasers for numerous but non-telecom applications. The drawback of broad waveguide lasers for telecom applications is the large beam divergence in the direction perpendicular to the laser plane (fast direction). For 1.5 $\mu$m lasers with a 1 $\mu$m thick waveguide this divergence exceeds 40 degrees at half maximum intensity (FWHM > 40°). This value of divergence is not compatible with effective laser coupling in single mode optical fiber. Methods of improving fast axis divergence are well known. For example, one method is to decrease the waveguide thickness down to 10-30 nm. However in the case of such narrow (NW) waveguide structures, a considerable portion (about 40%) of lasing mode propagates in the p-doped clad layer and optical losses caused by free hole absorption is high. As discussed above, the decrease of p-clad doping is not desirable because of electron leakage enhancement.

Thus, there is a need for a new design of telecom MQW low divergence lasers (especially pump lasers for fiber amplifiers) that provide high efficiency device operation at high current densities and elevated temperatures.

It is the object of the present invention to provide a method of improving efficiency of an opto-electronic device and a semiconductor opto-electronic device which provide for high efficiency operation at high current densities and elevated temperatures.

This object is fulfilled by a method being the features disclosed in claim 1 and a device having the features disclosed in claim 9. Preferred embodiments are defined in the dependent claims.

## SUMMARY OF THE INVENTION

A new design of telecom narrow waveguide low divergence diode light emitting sources, particularly for fiber amplifier pump laser, is disclosed. The design provides high efficiency operation at high current densities and elevated temperatures. To achieve this design, a large band gap blocking layer is incorporated coincident with the p/n junction within the device structure. The large band gap blocking layer material creates an electron energy barrier having a minimum 200 meV greater than adjacent material levels in the conduction band to prevent electron leakage from the active region to a p-doped clad region. In addition, a low doped, region of a wide band gap material is used in combination with the at least one blocking layer to decrease optical losses. In one aspect of the invention, a blocking layer is imposed between the low-doped region and the active region. In a second aspect of the invention the low-doped region is imposed between the blocking layer and the active region.

## BRIEF DESCRIPTION OF THE DRAWINGS

In the drawings:

Figure 1a illustrates a perspective view of a conventional semiconductor laser;
Figure 1b illustrates a conventional semiconductor laser conduction band diagram;
Figure 2a illustrates an exemplary semiconductor laser conduction band diagram in accordance with one aspect of one embodiment of the invention;
Figure 2b illustrates a second exemplary semiconductor laser conduction band diagram in accordance with a second aspect of the inventive concept illustrated in Figure 2a;

Figure 2c illustrates an exemplary semiconductor laser conduction band diagram in accordance with another aspect of the inventive concept illustrated in Figures 2a;

Figure 2d illustrates an exemplary semiconductor laser conduction band diagram in accordance with an aspect of the inventive concept illustrated in Figures 2a, 2b and 2c;

Figure 3a illustrates an exemplary semiconductor laser conduction band diagram in accordance with one aspect of a second embodiment of the invention;

Figure 3b illustrates a second exemplary semiconductor laser conduction band diagram in accordance with a second aspect of the inventive concept illustrated in Figure 3a;

Figure 3c illustrates an exemplary semiconductor laser conduction band diagram in accordance with a third aspect of the inventive concept illustrated in Figures 3a and 3b;

Figure 4a illustrates an exemplary cross-sectional epistructure of a conventional Quantum Well (QW) semiconductor radiation source device;

Figure 4b illustrates an exemplary cross-sectional epistructure of a QW semiconductor radiation source device in accordance with the principles of the invention;

Figure 5 illustrates a comparison of performance results of a conventional 1.48 micron pump laser and 1.48 micron pump laser having a conduction band diagram characteristic as illustrated in Figure 2a; and

Figure 6 illustrates P-I characteristics and power output spectra of a DFB laser fabricated in accordance with the principles of the invention.

It is to be understood that these drawings are solely for purposes of illustrating the concepts of the invention and are not intended as a level of the limits of the invention. It will be appreciated that the same reference numerals, possibly supplemented with reference characters where appropriate, have been used throughout to identify corresponding parts.

## DETAILED DESCRIPTION OF THE INVENTION

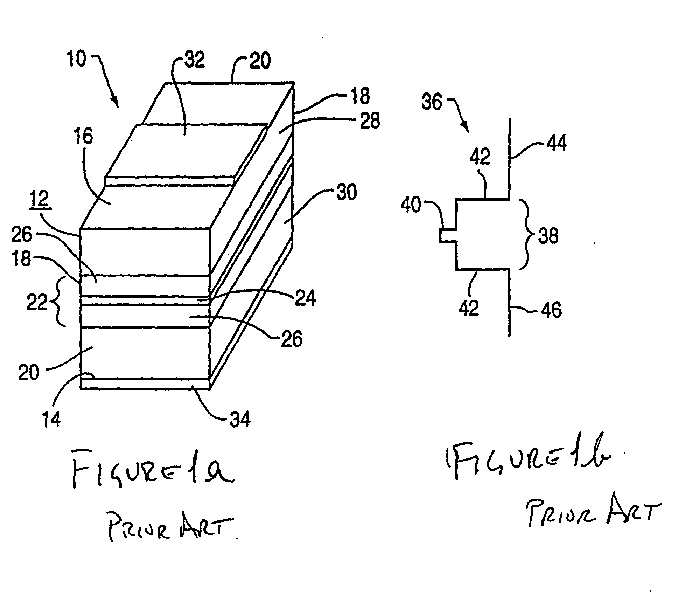

Referring to Figure 1a, which corresponds to Figure 1 of the referenced U.S. Patent No., 5,818,860, a semiconductor laser diode is designated as 10. Laser diode 10 comprises a body 12 of a semiconductor material or materials having a bottom surface 14, top surface 16, end surfaces 18 and side surfaces 20. The body 12 includes a waveguide region 22 extending thereacross. Within the waveguide region 22 is an active region 24 in which photons are generated when an appropriate electrical bias is placed across the diode 10. The active region 24 may be of any structure well known in the laser diode art that is capable of generating photons. The active region 24 comprises one or more quantum wells. The waveguide region 22 includes layers 26 on each side of the active region 24, which are of undoped semiconductor material.

On each side of the waveguide region 22 is a separate clad region 28 and 30. The clad regions 28 and 30 are layers of a semiconductor material of a composition, which has a lower refractive index than the materials of the layers 26 of the waveguide region 22. Also, the clad regions 28 and 30 are at least partially doped to be of opposite conductivity type. The doping level in the clad regions 28 and 30 are typically between about $5*10^{17}$/cm$^3$ and $2*10^{19}$/cm$^3$. For example, the clad region 28 between the waveguide region 22 and the top surface 16 of the body 12 may be of p-doped conductivity and the clad region 30 between the waveguide region 22 and the bottom surface 14 of the body 12 may be of n-doped conductivity.

A contact layer 32 of a conductive material, such as a metal, is on and in ohmic contact with the p-type conductivity clad region 28. The contact layer 32 is in the form of a strip that extends between the end surfaces 18 of the body 12 and is narrower than the width of the body 12, i.e., the distance between the side surfaces 20 of the body 12. A contact layer 34 of a conductive material, such as a metal, is on and in ohmic contact with the n-type conductivity clad region 30. The contact layer 34 extends across the entire area of the bottom surface 14 of the body 12.

The various regions of the body 12 may be made of any of the well known semiconductor materials used for making laser diode, such as but not limited to gallium arsenide (GaAs), aluminum gallium arsenide (Al-GaAs), indium phosphide (InP), indium gallium arsenide (InGaAs) and such quaternary materials as indium gallium arsenide phosphide (InGaAsP). However, the materials used for the various regions must have refractive indices, which provide the desired confinement of the optical mode. The clad regions 28 and 30 may be doped uniformly throughout their thickness or may be graded with little or no doping at their junction with the waveguide region 22 and the heaviest doping at the respective surface of the body 12.

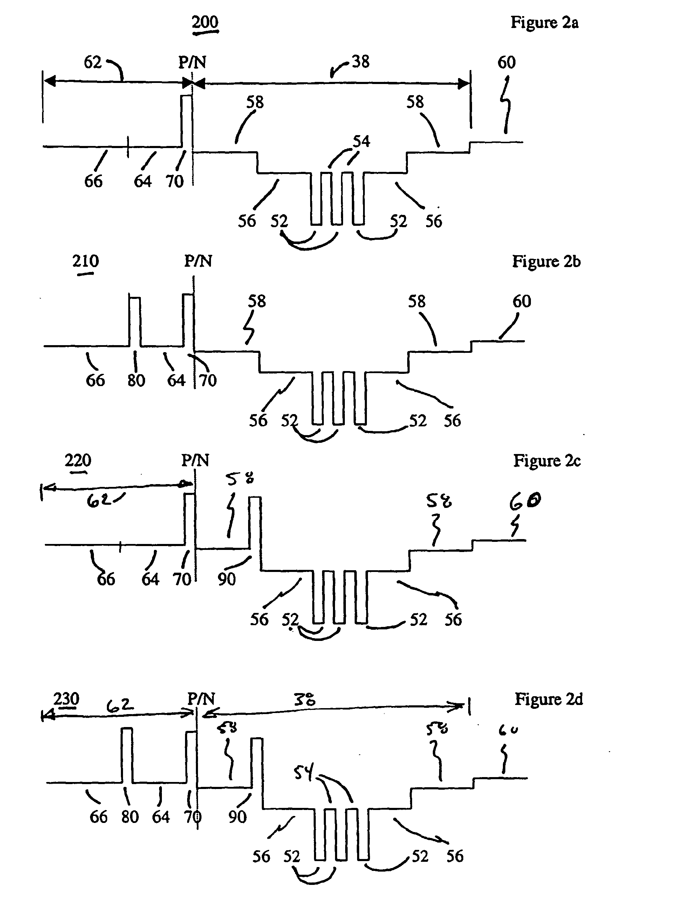

Referring to Figure 1b, which corresponds to Figure 2 of the referenced U.S. Patent No., 5,818,860, there is schematically shown the conduction band diagram 36 of a laser diode corresponding to the structure of laser diode 10 shown in FIG. 1a. In this schematic representation there is included a waveguide region 38 having therein a single quantum well region 40 of undoped material, e.g., $In_{20}Ga_{80}As$, and a separate confinement layer 42 of undoped material, e.g., $Al_{30}Ga_{70}As$, on each side of the quantum well region 40. A p-doped conductivity clad region 44 is on one side of the waveguide region 38 and an n-doped conductivity clad region 46 is on the other side of the waveguide region 38. Each of the clad regions 44 and 46 are of $Al_{60}Ga_{30}As$.

Although the laser diode 36 is shown as having only a single quantum well region 40, it may have a plurality of quantum well regions which are spaced apart by barrier regions as is well known in the laser diode art. Photons are generated as electrons drop into quantum well region 40 and confinement layer 42 inhibits the flow of electrons toward p-doped conductivity clad layer 44 and directs the generated photons travel along a known path.

Referring now to Figure 2a, there is schematically shown a conduction band diagram 200 of one aspect of an opto-electronic device, e.g., a semiconductor laser diode, in accordance with one embodiment of the present invention. In this representation of one embodiment of the invention, the semiconductor waveguide region 38 comprises a plurality of quantum well regions 52 composed of a semiconductor material, such as InGaAsP, which are spaced apart by barrier regions 54. Barrier regions 54 are composed of a semiconductor material, such as InGaAsP having a bandgap energy level represented herein as $Eg^{54}$. At each side of quantum well region 52 is illustrated inner confinement layer 56. Inner confinement layer 56 is composed of a material, such as InGaAsP having a bandgap energy level represented herein as $Eg^{56}$. As would be appreciated, the material of barrier level 54 may be the same or different than that of inner confinement layer 56. Adjacent to each of the inner confinement layers 56 is outer confinement layer 58. Outer confinement layer 58 is composed of a material such as InGaAsP having a bandgap energy level represented herein as $Eg^{58}$. As illustrated, the bandgap energy levels of the confinement regions are formulated such that:

$$Eg^{52} < Eg^{54} <= Eg^{56} < Eg^{58}$$

Adjacent to the outer confinement layers 58 are clad regions 60 and 62 composed of a material, such as InP, that is doped with impurities. Known impurities are added into clad region 60 to achieve an electron concentration, i.e., n-doped, and known impurities are added into clad region 62 to achieve a high hole concentration, i.e., p-doped. Clad regions 60 and 62 are generally doped, as previously discussed, to a level of greater that $5*10^{17}/cm^3$. Furthermore, n-dope type clad region 60 generally is uniformly doped throughout its thickness, but the p-dope type clad region 62 can have a doping level that is graded from a lowest level at the interface with the outer confinement layer 58 to a highest level at its surface. The energy band gap of clad regions 60 and 62 are significantly greater than the energy bandgap of outer confinement region 58.

In accordance with the principle of the invention, a tensile strained blocking layer 70 composed of a large band gap material, such as InGaP, which may also be p-doped, is interposed between outer confinement layer 58 and clad layer 62, i.e., coincident with p/n junction formed between p-type materials and n-type materials. Blocking layer 70 creates an energy barrier that prevents electrons from escaping, i.e., leaking, from the outer confinement region 58 to clad region 62. In this case, bandgap energy level of blocking layer 70, represented as $Eg^{70}$ is such that:

$$Eg^{58} < Eg^{62} < Eg^{70}$$

Blocking layer 70 should create a barrier of not less than 200 meV. The barrier created by blocking layer 70 decreases electron leakage down to one percent of the total drive current. Furthermore, blocking layer 70 is a relatively thin layer, 20-50 nanometers (nm). In a preferred embodiment, blocking layer 70 should not be less than 20 nm to avoid electron tunneling and not greater than 50 nm to decrease series resistance of the device and eliminate the formation of defects when the blocking layer is lattice mismatched with the substrate material.

In another aspect of the invention, clad region 62 is composed of a spacer region 64 and cladding region 66. In this aspect, cladding region 66 is a p-doped layer, as previously described. However, spacer region may be a p-doped InP material or InGaAsP material such that the electron bandgap is represented as:

$$Eg^{66} > Eg^{64} > Eg^{58}$$

In one aspect of the invention, spacer region 64 is a low p-doped in the order of $p=1*10^{17}$ to $2*10^{17}/cm^3$. Furtherstill, the hole concentration in cladding region 66 can be sharply increased up to $10^{18}/cm^3$.

Referring now to Figure 2b, there is schematically shown a conduction band diagram 210 of a second aspect of a semiconductor laser diode in accordance with the embodiment of the invention illustrated in Figure 2a. In this aspect of the invention, a second blocking layer 80 composed of a p-doped material, such as InGaP, is introduced at the interface of high-doped cladding region 66 and low-doped spacer layer 64. Second blocking layer 80 preferably is composed of a p-doped material having a doping level providing hole concentration greater than $2*10^{17}/cm^3$. This second blocking layer provides further suppression of the electron leakage current if some portion of the electrons penetrate blocking layer 70.

Referring now to Figure 2c, there is schematically shown a conduction band diagram 220 of another aspect of a semiconductor laser diode in accordance with the embodiment of the invention illustrated in Figure 2a. In this aspect of the invention, second blocking layer 90 is introduced at the interface of between outer confinement layer 58 and inner confinement layer 56. Preferably, blocking layer 80 is composed of n-doped material of a composition similar to that of blocking layer 70. In this aspect of the invention, the inclusion of second blocking layer 90 prevents electron accumulation in waveguide 38. This accumulation can cause additional optical losses due to free hole absorption in the waveguide layers.

Figure 2d schematically shows a conduction band diagram 230 of a fourth aspect of the present invention. In this aspect of the present invention, each of the previously described second blocking layers 80 and 90, respectively, are included within a fabricated semiconductor laser.

It should be understood that blocking layers 80 and 90 can be included individually or in combination to achieve a desired limitation of the leakage current outside waveguide region 38. Thus, although the inclusion of illustrated blocking layers to control the leakage current has been progressively shown in Figures 2a-2d, it is understood that the incorporation of one blocking layer is independent of other blocking layers. Hence, other combinations of the illustrated blocking layers, although not illustrated, are contemplated as being within the scope of the invention.

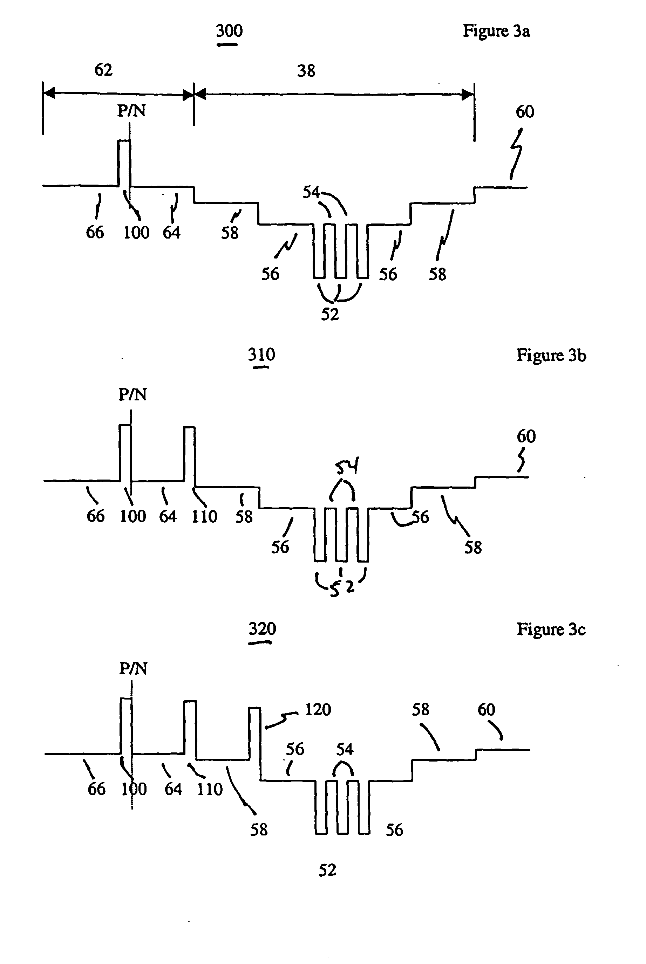

Referring now to Figures 3a-3c, there are shown conduction band diagrams corresponding to a second embodiment of the invention. In this illustrative example, blocking layers are progressively included within the semiconductor material in accordance with the principles of the invention. Referring to Figure 3a, there is illustrates a conduction band diagram 300, depicting a blocking layer 100 of p-doped semiconductor material layer, such as InGaP, formed at the junction of p-doped portion 66 and n-doped portion 64 of clad layer 62. In one aspect of the invention, blocking layer may be tensile strained. The p-doped blocking layer 100, as previously discussed, creates an electron barrier that inhibits the flow of electrons from waveguide region 38 to p-doped portion of cladding region 66. The adjacent low n-doped portion 64 of clad layer 62 has an electron concentration less than $5 \times 10^{17}$/cm³. At the interface between the low n-doped layer 64 and the p-doped portion 66 of clad layer 62 the hole concentration increases sharply up to $10^{18}$/cm³. This increase in the p-doping provides a low resistance for the device.

Figure 3b illustrates a second aspect of the invention, wherein an n-doped, strained, blocking layer 110 of a material, such as InGaP, is formed at the interface of outer confinement layers 58 and low doped spacer region 64. In this aspect of the invention, spacer region 64 is an undoped material, such as InP. This additional blocking layer provides further suppression of a electron leakage current.

Figure 3c illustrates another aspect of the invention, wherein a second n-doped blocking layer 120 of a material, such as InGaP, is incorporated at the interface between inner confinement layer 56 and outer confinement layer 58. Blocking layer 120 prevents electron accumulation in waveguide 38. Accumulation of electrons in waveguide 38 can create additional optical losses due to free hole absorption in the waveguide layers.

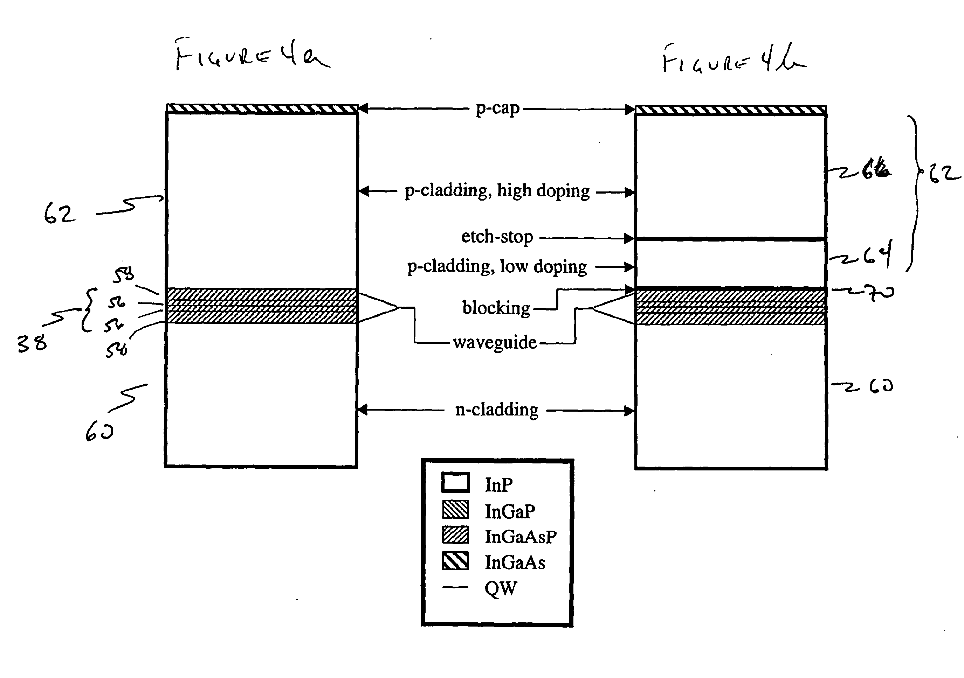

Figure 4a depicts a cross-sectional view of an exemplary conventional diode radiation source. In this view, the material layers that compose the device are shown. Hence, n-doped clad layer 60 is composed of a InP material. Active region 38 composed of outer confinement layer 58, inner confinement layer 56 and quantum well 52 is composed on a InGaAsP material. And p-doped clad layer 62 is composed of an InP material.

Figure 4b depicts a cross-section view of an exemplary semiconductor light emitting device constructed in accordance with one aspect of the invention. More specifically, Figure 4b illustrates an opto-electronic device having a conduction band diagram similar to that illustrated Figure 2a. In this illustrative example, blocking layer 70 in interposed at the interface between waveguide layer 38 and p-doped clad layer 62. As is further illustrated, p-doped clad layer 62 is composed of a high-doped 66 portion and a low-doped portion 64. An etch-stop layer is included in the fabrication process to isolate the high-doped layer 66 from low-doped layer 64. In one aspect of the invention, the thickness of low-doped layer 64 may be selected to as:

$$d \geq \frac{\lambda}{2}\phi$$

where d is said low doped material thickness;
λ is an operational wavelength; and
φ is a desired beam divergence expressed in radians.

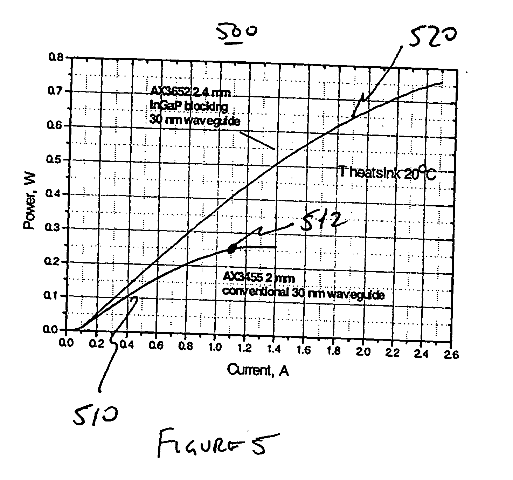

Figure 5 depicts a graph 500 illustrating the performance of output power with respect to input current for both a conventional semiconductor laser and a semiconductor laser incorporating the features of the present invention. In this example, the semiconductor laser of the present invention is constructed having a conduction band diagram similar to that illustrated in Figure 2a. As is represented by graph 510, the output power of the conventional laser increases with increased input current up to a known level 512. Thereafter, the output power remains substantially constant for any increase in current. On the other hand, the output power, as represented by graph 520, of the laser device incorporating blocking layer technology of the present invention, increases linearly with increasing input current achieving a power of 750mW. Hence, the radiation source device in accordance with principles of the invention experiences a substantially linear increase in output power with input current and does not experience a saturation output power with increased input current.

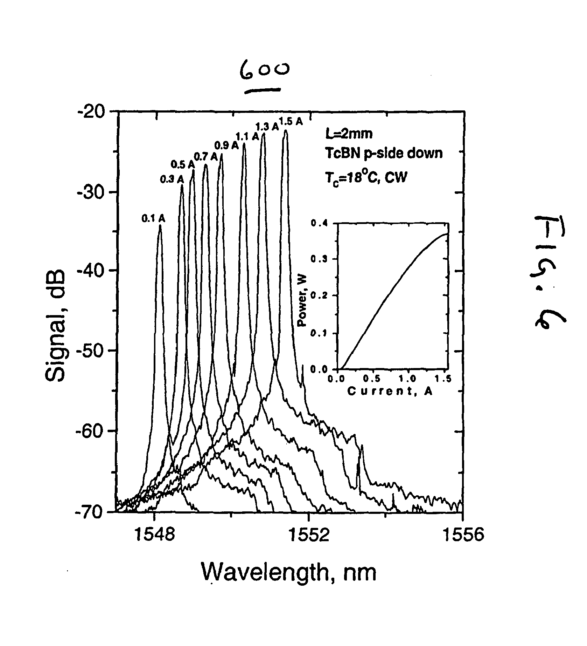

Figure 6 graphically illustrates the P-I characteristics, in the insert box, and the output power spectra of a single-mode, single-frequency DFB laser fabricated in accordance with the principles of the present invention. As illustrated, as input current increases, the output power increases, up to 370mW, while the spectra remains substantially single frequency. Furthermore, the intensity of the side modes remains significantly lower than the main output. This performance is advantageous, particularly in telecommunication systems, as the narrow frequency operation limits interference from one carrier wavelength to another.

Although the invention has been described and discussed with regard to semiconductor lasers as a preferred form with a certain degree of particularity, it is understood that the present disclosure of the preferred form, has been made only by way of example, and that numerous changes in the details may be made without departing from the scope of the invention as hereinafter claimed. For example, the method of incorporating blocking layers to prevent the leakage of electron current may also be used in other opto-electronic devices, such as gain chips, SLEDs, optical amplifiers, DFB lasers, etc.

## Claims

1. A method of improving efficiency of an opto-electronic device composed of a plurality of semiconductor materials adjacently connected having different compositions, wherein a junction is formed between p-type composition materials (62) and n-type composition materials (38), said method comprising:

    imposing a blocking layer (70, 100) coincident with said p/n junction wherein said blocking layer (70, 100) is formed from a material composition having an electronic band gap that forms a barrier to inhibit electrons from traversing from an active region in said n-type materials to p-type materials; and
    imposing a low-doped layer (64) adjacent to said blocking layer (70, 100), said low-doped layer (64) comprising a material having a doping level lower than an adjacently connected material,

    wherein the band gap of the blocking layer (70, 100) is larger than band gaps of one or more layers (58, 64, 66) adjacent to the blocking layer (70, 100), **characterized in that** said p-type composition materials form a clad region (62) and said n-type composition materials form a waveguide region (38).

2. The method as recited in Claim 1 further comprising:

    imposing at least one second blocking layer (80) at at least one interface between adjacently connected materials, wherein a material composition comprising said imposed second blocking layer (80) has at least one second electronic band gap that forms a barrier to inhibit electrons from traversing said at least one interface.

3. The method as recited in Claim 1 wherein

    said plurality of materials is selected from the group comprising InGaAsP/InP, InAlGaAs/InP, AlGaAs/GaAs, AlInGaAsSb/GaAs, InGaAlPAs/GaAs; or

    wherein said blocking layer (70) is interposed between said low-doped layer (64) and said active region; or wherein said low-doped layer (64) is interposed between said blocking layer (100) and said active region; or
    wherein said blocking layer (70, 100) is p-doped; or
    wherein said blocking layer (70, 100) thickness is in the range of 20-50 nanometers; or
    wherein said low-doped layer (64) thickness is determined as:

    $$d \geq \frac{\lambda}{2}\phi$$

    where d is said low-doped layer (64) thickness, $\lambda$ is an operational wavelength; and
    $\phi$ is a desired beam divergence in a direction perpendicular to the plane of the blocking layer (70, 100), expressed in radians.

4. The method as recited in Claim 1 wherein said blocking layer (70, 100) material is selected from the group comprising InGaP, InAlAs, InAlGaAs, GaP, AlAs.

5. The method as recited in Claim 2 wherein said at least one second blocking layer (80) material is selected from the group comprising InGaP, InAlAs, InAlGaAs, GaP, AlAs.

6. The method as recited in Claim 4 wherein a magnitude of said electronic band gap is at least 200 meV greater than a magnitude of an electronic band gap of an adjacent material layer (58, 64, 66).

7. The method as recited in Claim 5 wherein a magnitude of said second electronic band gap is at least 200 meV greater than a magnitude of an electronic band gap of an adjacent material layer (58, 64, 66).

8. The method as recited in Claim 2 wherein each of said at least one blocking layer (70, 100) is in the range of 20-50 nanometers.

9. A semiconductor opto-electronic device comprising:

    a clad region (62) and a waveguide region (38), and a p/n junction formed therebetween, said clad region (62) having a lower refractive index than said waveguide region (38) and said waveguide region (38) including an active region containing at least one quantum well (52) for the generation of photons therein;
a blocking layer (70, 100) having an electronic band gap creating a barrier coincident with said p/n junction that inhibits electron leakage from said active region to said clad region (62); and
a low-doped layer (64) adjacent to said blocking layer (70, 100), said low-doped layer (64) comprising a material having a doping level lower than an adjacently connected material (58, 64, 66);

wherein the band gap of the blocking layer (70, 100) is larger than band gaps of one or more layers (58, 64, 66) adjacent to the blocking layer (70, 100), **characterized in that** said clad region (62) is p-type and said waveguide region (38) is n-type.

10. The device as recited in Claim 9 wherein said blocking layer (70, 100) thickness is in the range of 20-50 nanometers; or
wherein a magnitude of said electronic band gap is at least 200 meV greater than a magnitude of an electronic band gap of an adjacent region (58, 64, 66); or
wherein said low-doped layer (64) is interposed between said clad region (62) and said blocking layer (100); or
wherein said low-doped layer (64) is interposed between said blocking layer (100) and said active region; or
wherein said p/n junction is formed at the interface between said clad region (62) and said waveguide region (38); or
wherein said p/n junction is formed within said clad region (62); or
wherein said clad region (62) and said waveguide region (38) are composed of materials selected from the group consisting of InGaAsP/InP, InAlGaAs/InP, AlGaAs/GsAs, AlInGaAsSb/GaAs, InGaAlPAs/GaAs; or
wherein said blocking layer (100) is interposed between said low-doped layer (64) and said active region; or
wherein said blocking layer (70, 100) is p-doped; or
wherein said blocking layer (70, 100) material is selected from the group comprising InGaP, InAlAs, InAlGaAs, GaP, AlAs; or
wherein said low-doped layer (64) thickness is determined as:

$$d \geq \frac{\lambda}{2}\phi$$

where d is said low-doped layer (64) thickness, $\lambda$ is an operational wavelength, and

$\phi$ is a desired beam divergence in a direction perpendicular to the plane of the blocking layer (70, 100), expressed in radians.

11. The device as recited in Claim 9 wherein said waveguide region (38) is further composed of at least one confinement layer (56) having a band gap energy level equal to or greater than band gap energy levels of quantum well regions (52) of the waveguide region (38) and barrier regions (54) of the waveguide region (38).

12. The device as recited in Claim 11 further comprising a second blocking layer (90) interposed adjacent said at least one confinement layer (56), wherein a material composition comprising said second blocking layer (90) has at least one second electronic band gap that forms a barrier to inhibit electrons from traversing said confinement layer (56).

13. The device as recited in Claim 12 wherein a magnitude of said second electronic band gap is at least 200 meV greater than a magnitude of an electronic band gap of an adjacent layer (58, 64, 66); or
wherein said second blocking layer (90) is composed of material is selected from the group comprising InGaP, InAlAs, InAlGaAs, GaP, AlAs; or
wherein said second blocking layer (90) thickness is in the range of 20-50 nanometers.

**Patentansprüche**

1. Verfahren zum Verbessern eines Wirkungsgrads einer optoelektronischen Vorrichtung, die aus einer Mehrzahl von benachbart verbundenen bzw. angeschlossenen Halbleitermaterialien zusammengesetzt ist, die unterschiedliche Zusammensetzungen aufweisen, wobei ein Übergang zwischen einem p-Typ-Zusammensetzungsmaterial (62) und einem n-Typ-Zusammensetzungsmaterial (38) ausgebildet ist, wobei das Verfahren umfaßt:

Anordnen bzw. Zwischenlagern einer blockierenden bzw. Blockierschicht (70, 100), die mit dem p/n Übergang zusammenfällt, wobei die Blockierschicht (70, 100) aus einer Materialzusammensetzung gebildet wird, die eine elektronische Bandlücke aufweist, welche eine Barriere ausbildet, um Elektronen am Queren bzw. Bewegen von einem aktiven Bereich in den n-Typ-Materialien zu p-Typ-Materialien zu hindern; und
Zwischenlagern einer niedrig dotierten Schicht (64) benachbart der Blockierschicht (70, 100), wobei die niedrig dotierte Schicht (64) ein Material umfaßt, das ein Dotierniveau niedriger als ein benachbart verbundenes bzw. angeschlossenes Material aufweist;

wobei die Bandlücke der Blockierschicht (70, 100) größer als die Bandlücken von einer oder mehreren Schicht(en) (58, 64, 66) benachbart bzw. angrenzend der Blockierschicht (70, 100) ist, **dadurch gekennzeichnet, daß** die p-Typ-Zusammensetzungsmaterialien einen Cledding- bzw. Mantel- bzw. Umhüllungsbereich (62) ausbilden und die n-Typ-Zusammensetzungsmaterialien einen Wellenleiterbereich (38) ausbilden.

2. Verfahren nach Anspruch 1, weiterhin umfassend:

Zwischenlagern von wenigstens einer zweiten Blockierschicht (80) an wenigstens einer Zwischen- bzw. Grenzfläche zwischen benachbart bzw. angrenzend verbundenen Materialien, wobei eine Materialzusammensetzung, umfassend die zwischengelagerte zweite Blockierschicht (80), wenigstens eine zweite elektronische Bandlükke aufweist, welche eine Barriere ausbildet, um Elektronen am Durchqueren der wenigstens einen Grenzfläche zu hindern.

3. Verfahren nach Anspruch 1, wobei die Mehrzahl von Materialien aus der Gruppe gewählt wird, umfassend InGaAsP/InP, InAlGaAs/InP, AlGaAs/GaAs, AlInGaAsSb/GaAs, InGaAlPAs/GaAs; oder wobei die Blockierschicht (70) zwischen der niedrig dotierten Schicht (64) und dem aktiven Bereich zwischengelagert wird; oder wobei die niedrig dotierte Schicht (64) zwischen der Blockierschicht (100) und dem aktiven Bereich zwischengelagert wird; oder wobei die Blockierschicht (70, 100) p-dotiert ist; oder wobei die Dicke der Blockierschicht (70, 100) in dem Bereich von 20-50 Nanometer liegt; oder wobei die Dicke der niedrig dotierten Schicht (64) bestimmt wird als:

$$d \geq \frac{\lambda}{2}\phi$$

wo d die Dicke der niedrig dotierten Schicht (64) ist,
$\lambda$ eine Betriebs- bzw. Betätigungswellenlänge ist; und
$\phi$ eine gewünschte Strahldivergenz in einer Richtung senkrecht zu der Ebene der Blockierschicht (70, 100), ausgedrückt in Radian ist.

4. Verfahren nach Anspruch 1, wobei das Material der Blockierschicht (70, 100) aus der Gruppe gewählt wird, umfassend InGaP, InAlAs, InAlGaAs, GaP, AlAs.

5. Verfahren nach Anspruch 2, wobei das Material der wenigstens einen zweiten Blockierschicht (80) aus der Gruppe gewählt wird, umfassend InGaP, InAlAs, InAlGaAs, GaP, AlAs.

6. Verfahren nach Anspruch 4, wobei eine Größe der elektronischen Bandlücke wenigstens 200 meV größer als eine Größe einer elektronischen Bandlücke einer benachbarten bzw. angrenzenden Materialschicht (58, 64, 66) ist.

7. Verfahren nach Anspruch 5, wobei eine Größe der zweiten elektronischen Bandlücke wenigstens 200 meV größer als eine Größe einer elektronischen Bandlücke einer benachbarten bzw. angrenzenden Materialschicht (58, 64, 66) ist.

8. Verfahren nach Anspruch 2, wobei jede der wenigstens einen Blockierschicht (70, 100) in dem Bereich von 20-50 Nanometer liegt.

9. Optoelektronische Halbleitervorrichtung, umfassend:

einen Cledding- bzw. Mantel- bzw. Umhüllungsbereich (62) und einen Wellenleiterbereich (38) und einen p/n Übergang, der dazwischen ausgebildet ist, wobei der Cleddingbereich (62) einen niedrigeren Brechungsindex als der Wellenleiterbereich (38) aufweist und der Wellenleiterbereich (38) einen aktiven Bereich beinhaltet, enthaltend wenigstens einen Quantenwell- bzw. -topf (52) zur Ausbildung von Photonen darin; eine Blockierschicht (70, 100), die eine elektronische Bandlücke aufweist, die eine Barriere ausbildet, die mit dem p/n Übergang zusammenfällt, welcher ein Elektronenlecken von dem aktiven Bereich zu dem Cleddingbereich (62) inhibiert bzw. hemmt; und eine niedrig dotierte Schicht (64) benachbart bzw. angrenzend der Blockierschicht (70, 100), wobei die niedrig dotierte Schicht (64) ein Material umfaßt, das ein Dotierniveau niedriger als ein benachbart bzw. angrenzend verbundenes bzw. angeschlossenes Material (58, 64, 66) aufweist;

wobei die Bandlücke von der Blockierschicht (70, 100) größer als Bandlücken von einer oder mehreren Schicht(en) (58, 64, 66) benachbart bzw. angrenzend der Blokkierschicht (70, 100) ist, **dadurch gekennzeichnet, daß** der Cleddingbereich (62) ein p-Typ ist und der Wellenleiterbereich (38) ein n-Typ ist.

10. Vorrichtung nach Anspruch 9, wobei die Dicke der Blockierschicht (70, 100) in dem Bereich von 20-50 Nanometer liegt; oder

wobei eine Größe der elektronischen Bandlücke wenigstens 200 meV größer als eine Größe einer elektronischen Bandlücke eines benachbarten bzw. angrenzenden Bereichs (58, 64, 66) ist; oder

wobei die niedrig dotierte Schicht (64) zwischen dem Cleddingbereich (62) und dem Blockierbereich (100) angeordnet bzw. zwischengelagert ist; oder

wobei die niedrig dotierte Schicht (64) zwischen der Blockierschicht (100) und dem aktiven Bereich zwischengelagert ist; oder

wobei der p/n Übergang an der Zwischen- bzw. Grenzfläche zwischen dem Cleddingbereich (62) und dem Wellenleiterbereich (38) ausgebildet ist; oder

wobei der p/n Übergang in dem Cleddingbereich (62) ausgebildet ist; oder

wobei der Cleddingbereich (62) und der Wellenleiterbereich (38) aus Materialien zusammengesetzt sind, gewählt aus der Gruppe, bestehend aus InGaAsP/InP, InAlGaAs/InP, AlGaAs/ GsAs, AlInGaAsSb/GaAs, InGaAlPAs/GaAs; oder

wobei die Blockierschicht (100) zwischen der niedrig dotierten Schicht (64) und dem aktiven Bereich zwischengelagert ist; oder

wobei die Blockierschicht (70, 100) p-dotiert ist; oder

wobei das Material der Blockierschicht (70, 100) aus der Gruppe gewählt ist, umfassend InGaP, InAlAs, InAlGaAs, GaP, AlAs; oder

wobei die Dicke der niedrig dotierten Schicht (64) bestimmt ist als:

$$d \geq \frac{\lambda}{2}\phi$$

wo d die Dicke der niedrig dotierten Schicht (64) ist,

λ eine Betätigungs- bzw. Betriebswellenlänge ist, und

φ eine gewünschte Strahldivergenz in einer Richtung senkrecht zu der Ebene der Blockierschicht (70, 100), ausgedrückt in Radian ist.

11. Vorrichtung nach Anspruch 9, wobei der Wellenleiterbereich (38) weiterhin aus wenigstens einer Begrenzungsschicht (56) zusammengesetzt ist, die ein Bandlücken-Energieniveau gleich oder größer als Bandlücken-Energieniveaus von Quantenwell- bzw. -topfbereichen bzw. -regionen (52) des Wellenleiterbereichs (38) und Barrierebereichen (54) des Wellenleiterbereichs (38) aufweist.

12. Vorrichtung nach Anspruch 11, weiterhin umfassend eine zweite Blockierschicht (90), die benachbart der wenigstens einen Begrenzungsschicht (56) zwischengelagert ist, wobei eine Materialzusammensetzung, umfassend die zweite Blockierschicht (90), wenigstens eine zweite elektronische Bandlücke aufweist, die eine Barriere ausbildet, um Elektronen am Queren bzw. Durchqueren der Begrenzungsschicht (56) zu hindern.

13. Vorrichtung nach Anspruch 12, wobei eine Größe der zweiten elektronischen Bandlücke wenigstens 200 meV größer als eine Größe einer elektronischen Bandlücke einer benachbarten bzw. angrenzenden Schicht (58, 64, 66) ist; oderwobei die zweite Blokkierschicht (90) aus Material zusammengesetzt ist, das aus der Gruppe gewählt ist, umfassend InGaP, InAlAs, InAlGaAs,GaP, AlAs; oder

wobei die Dicke der zweiten Blockierschicht (90) in dem Bereich von 20-50 Nanometer liegt.

## Revendications

1. Procédé d'amélioration de l'efficacité d'un dispositif optoélectronique constitué d'une pluralité de matériaux semi-conducteurs connectés de manière adjacente et ayant différentes compositions, dans lequel une jonction est formée entre les matériaux de composition de type p (62) et les matériaux de composition de type n (38), ledit procédé comprenant les étapes consistant à :

imposer une couche de blocage (70, 100) qui coïncide avec ladite jonction p/n, où ladite couche de blocage (70, 100) est formée à partir d'une composition de matériau ayant une bande interdite électronique qui forme une barrière pour empêcher les électrons de traverser depuis- une région active dans lesdits matériaux de type n vers les matériaux de type p ; et imposer une couche faiblement dopée (64) adjacente à ladite couche de blocage (70, 100), ladite couche faiblement dopée (64) comprenant un matériau ayant un niveau de dopage inférieur à celui d'un matériau connecté de manière adjacente,

dans lequel la bande interdite de la couche de blocage (70, 100) est plus grande que les bandes interdites d'une ou de plusieurs couches (58, 64, 66) adjacentes à la couche de blocage (70, 100) ; **caractérisé en ce que** lesdits matériaux de type p forment une région de gaine (62) et lesdits matériaux de composition de type n forment une région de guide d'onde (38).

2. Procédé selon la revendication 1, comprenant en outre les étapes consistant à :

imposer au moins une seconde couche de blocage (80) à au moins une interface entre des matériaux connectés de manière adjacente, dans lequel une composition de matériau comprenant ladite seconde couche de blocage imposée (80) a au moins une seconde bande interdite électronique qui forme une barrière pour empêcher les électrons de traverser ladite au moins une interface.

**3.** Procédé selon la revendication 1, dans lequel :

ladite pluralité de matériaux est sélectionnée dans le groupe constitué d'InGaAsP/InP, d'InAlGaAs/InP, d'AlGaAs/GaAs, d'AlInGaAsSb/GaAs, d'InGaAlPAs/GaAs ; ou

dans lequel ladite couche de blocage (70) est interposée entre ladite couche faiblement dopée (64) et ladite région active ; ou dans lequel ladite couche faiblement dopée (64) est interposée entre ladite couche de blocage (100) et ladite région active ; ou dans lequel ladite couche de blocage (70, 100) est dopée p ; ou

dans lequel l'épaisseur de ladite couche de blocage (70, 100) s'étend de 20 à 50 nanomètres ; ou

dans lequel l'épaisseur de ladite couche faiblement dopée (64) est déterminée par :

$$d \geq \frac{\lambda}{2}\phi$$

où d est l'épaisseur de ladite couche faiblement dopée (64),
λ est une longueur d'onde opérationnelle ; et
Φ est une divergence de faisceau souhaitée dans une direction perpendiculaire au plan de la couche de blocage (70, 100), exprimée en radian.

**4.** Procédé selon la revendication 1, dans lequel le matériau de ladite couche de blocage (70, 100) est sélectionné dans le groupe constitué d'InGaP, d'InAlAs, d'InAlGaAs, de GaP et d'AlAs.

**5.** Procédé selon la revendication 2, dans lequel le matériau de ladite au moins une seconde couche de blocage (80) est sélectionné dans le groupe constitué d' InGaP, d'InAlAs, d' InAlGaAs, de GaP et d'AlAs.

**6.** Procédé selon la revendication 4, dans lequel une largeur de ladite bande interdite électronique est au moins 200 meV plus élevée qu'une largeur d'une bande interdite électronique d'une couche de matériau adjacente (58, 64, 66).

**7.** Procédé selon la revendication 5, dans lequel une largeur de ladite seconde bande interdite électronique est au moins 200 meV plus élevée qu'une largeur d'une bande interdite électronique d'une couche de matériau adjacente (58, 64, 66).

**8.** Procédé selon la revendication 2, dans lequel chacune desdites au moins une couche de blocage (70, 100) a une épaisseur s'étendant de 20 à 50 nanomètres.

**9.** Dispositif optoélectronique semi-conducteur comprenant :

une région de gaine (62) et une région de guide d'onde (38), et une jonction p/n formée entre elles, ladite région de gaine (62) ayant un indice de réfraction inférieur à celui de ladite région de guide d'onde (38), et ladite région de guide d'onde (38) comprenant une région active contenant au moins un puits quantique (52) pour la génération de photons dans celui-ci ;
une couche de blocage (70, 100) ayant une bande interdite électronique créant une barrière qui coïncide avec ladite jonction p/n qui empêche la fuite d'électrons depuis ladite région active vers ladite région de gaine (62) ; et
une couche faiblement dopée (64) adjacente à la dite couche de blocage (70, 100), ladite couche faiblement dopée (64) comprenant un matériau ayant un niveau de dopage inférieur à celui d'un matériau connecté de manière adjacente (58, 64, 66) ;

dans lequel la bande interdite de la couche de blocage (70, 100) est plus large que les bandes interdites d'une ou de plusieurs couches (58, 64, 66) adjacentes à la couche de blocage (70, 100) ;
**caractérisé en ce que** ladite région de gaine (62) est de type p et ladite région de guide d'onde (38) est de type n.

**10.** Dispositif selon la revendication 9, dans lequel l'épaisseur de ladite couche de blocage (70, 100) s'étend de 20 à 50 nanomètres ; ou
dans lequel une largeur de ladite seconde bande interdite électronique est au moins 200 meV plus élevée qu'une largeur d'une bande interdite électronique d'une région adjacente (58, 64, 66) ; ou
dans lequel ladite couche faiblement dopée (64) est interposée entre ladite région de gaine (62) et ladite couche de blocage (100) ; ou
dans lequel ladite couche faiblement dopée (64) est interposée entre ladite couche de blocage (100) et ladite région active ; ou
dans lequel ladite jonction p/n est formée à l'interface entre ladite région de gaine (62) et ladite région de guide d'onde (38) ; ou
dans lequel ladite jonction p/n est formée à l'intérieur de ladite région de gaine (62) ; ou
dans lequel ladite région de gaine (62) et ladite région de guide d'onde (38) sont composées de matériaux sélectionnés dans le groupe constitué d'InGaAsP/InP, d'InAlGaAs/InP, d'AlGaAs/GaAs, d'AlInGaAsSb/GaAs, d'InGaAlPAs/GaAs ; ou

dans lequel ladite couche de blocage (100) est interposée entre ladite couche faiblement dopée (64) et ladite région active ; ou

dans lequel ladite couche de blocage (70, 100) est dopée p ; ou

dans lequel le matériau de ladite couche de blocage (70, 100) est sélectionné dans le groupe constitué d'InGaP, d'InAlAs, d'InAlGaAs, de GaP, d'AlAs ; ou

dans lequel l'épaisseur de ladite couche faiblement dopée (64).est déterminée par :

$$d \geq \frac{\lambda}{2} \phi$$

où d est l'épaisseur de ladite couche faiblement dopée (64),

λ est une longueur d'onde opérationnelle ; et

Φ est une divergence de faisceau souhaitée dans une direction perpendiculaire au plan de la couche de blocage (70, 100), exprimée en radian.

11. Dispositif selon la revendication 9, dans lequel ladite région de guide d'onde (38) est en outre composée d'au moins une couche de confinement (56) ayant un niveau d'énergie de bande interdite égal ou supérieur aux niveaux d'énergie de bande interdite de régions de puits quantiques (52) de la région de guide d'onde (38) et des régions de barrière (54) de la région de guide d'onde (38).

12. Dispositif selon la revendication 11, comprenant en outre une seconde couche de blocage (90) interposée de manière adjacente à ladite au moins une couche de confinement (56), dans lequel une composition de matériau comprenant ladite seconde couche de blocage (90) a au moins une seconde bande interdite électronique qui forme une barrière pour empêcher les électrons de traverser ladite couche de confinement (56).

13. Dispositif selon la revendication 12, dans lequel une largeur de ladite seconde bande interdite électronique est au moins 200 meV plus élevée qu'une largeur d'une bande interdite électronique d'une région adjacente (58, 64, 66) ; ou

dans lequel ladite seconde couche de blocage (90) est composée d'un matériau sélectionné dans le groupe constitué d'InGaP, d'InAlAs, d'InAlGaAs, de GaP, d'AlAs ; ou

dans lequel l'épaisseur de ladite seconde couche de blocage (90) s'étend de 20 à 50 nanomètres.

FIGURE 1a

PRIOR ART.

FIGURE 1b

PRIOR ART

**200**

P/N

62

38

60

58 58

66 64 70

56 52 54 52 56

Figure 2a

---

**210**

P/N

58 58 60

66 80 64 70

56 52 52 56

Figure 2b

---

**220**

P/N

62

58

58 60

66 64 70 90

56 52 54 52 56

Figure 2c

---

**230**

62

P/N

38

58

58 60

66 80 64 70 90

56 52 54 52 56

Figure 2d

Figure 3a

Figure 3b

Figure 3c

FIGURE 4a

FIGURE 4b

62

58
56
52
54
38

60

p-cap

p-cladding, high doping

etch-stop

p-cladding, low doping

blocking

waveguide

n-cladding

266    62
264
270
260

InP
InGaP
InGaAsP
InGaAs
— QW

EP 1 380 077 B1

FIGURE 5

FIG. 6